# EUROPEAN PATENT SPECIFICATION

(11) **EP 3 944 301 B1**
(45) Date of publication and mention of the grant of the patent: **06.08.2025**
(21) Application number: 21785747.3
(22) Date of filing: 26.03.2021
(51) Int. Cl.: H01L 21/308, H01L 21/762, H10B 12/00

(54) **SEMICONDUCTOR STRUCTURE AND MANUFACTURING METHOD THEREFOR**
HALBLEITERSTRUKTUR UND HERSTELLUNGSVERFAHREN DAFÜR
STRUCTURE SEMI-CONDUCTRICE ET SON PROCÉDÉ DE FABRICATION

(30) Priority: 20.05.2020 CN 202010428538
(43) Date of publication of application: 26.01.2022
(73) Proprietor: Changxin Memory Technologies, Inc., Hefei City, Anhui 230000 (CN)
(72) Inventor: ZHU, Yiming, Anhui 230000 (CN); YING, Zhan, Anhui 230000 (CN); ZHANG, Qiang, Anhui 230000 (CN)
(74) Representative: Lavoix
(86) International application number: PCT/CN2021/083119
(87) International publication number: WO 2021/232936

(56) References cited:
- CN-A- 1 983 601
- CN-A- 104 051 346
- CN-A- 107 230 702
- CN-A- 108 807 282
- US-A1- 2003 017 671
- US-A1- 2007 051 994
- US-A1- 2012 119 289
- US-A1- 2016 163 543
- US-A1- 2020 091 311

## Description

### CROSS-REFERENCE TO RELATED APPLICATION

This application claims priority to Chinese Patent Application No. 202010428538.8, filed on May 20, 2020, entitled "A SEMICONDUCTOR DEVICE AND A METHOD MAKING THE SAME".

### TECHNICAL FIELD

The present application relates to a semiconductor device structure and a method for making the same.

### BACKGROUND

Dynamic random access memory (DRAM) is a kind of semiconductor memory devices widely used in multiple computer systems. With the development of semiconductor integrated circuit device technologies, the critical dimensions of the dynamic random access memory are getting ever smaller. For example, the active areas (AA) are becoming increasingly smaller, setting very high requirements for corresponding semiconductor manufacturing process. Related technologies are known from US2016/0163543A1, US2012/0119289A1, and US2007/051994A1.

### SUMMARY

The invention is defined by the independent claim. According to the present invention, a method for manufacturing a semiconductor device structure is described.

### BRIEF DESCRIPTION OF THE DRAWINGS

In order to more clearly illustrate the technical solutions in the embodiments of the present application, the following will briefly introduce the drawings needed in the embodiments. Apparently, the drawings in the following description are only some embodiments of the present application for those of ordinary skill in the art, without creative work, other drawings can be obtained from these drawings.
FIG. 1 is a flow chart of the method for preparing the semiconductor structure of the present disclosure;
FIG. 2 shows a schematic diagram of a perspective view of the substrate having a plurality of first trenches obtained in step S2 according to an embodiment of the present disclosure;
FIG. 3 shows a schematic diagram of a perspective view of the semiconductor structure obtained in step S21 according to an embodiment of the present disclosure;
FIG. 4 shows a schematic diagram of a perspective view of the semiconductor structure obtained after removing the first dielectric layer from the bottom of the first trenches according to an embodiment of the present disclosure;
FIG. 5 shows a schematic diagram of a perspective view of the semiconductor structure obtained in step S22 according to an embodiment of the present disclosure;
FIG. 6 is a schematic diagram of a perspective view of the semiconductor structure obtained in step S312 according to an embodiment of the present disclosure;
FIG. 7 shows a schematic diagram of a perspective view of the semiconductor structure obtained in step S314 according to an embodiment of the present disclosure;
FIG. 8 shows a schematic diagram of a perspective view of the semiconductor structure obtained in step S32 according to an embodiment of the present disclosure;
FIG. 9 is a flowchart of an exemplary method of step S2 according to an embodiment of the present disclosure; and
FIG. 10 is a flowchart of an exemplary method of step according to an embodiment of the present disclosure.

Reference numerals in the figures: 1. Substrate; 11. First pattern; 111. Second pattern; 12. First trench; 112. Second trench; 2. First dielectric layer; 3. Patterned mask layer; 31. Opening pattern; 4. The second dielectric layer; and 5. The third dielectric layer.

### DETAILED DESCRIPTION

As the width of an active area is very narrow, the ends of such elongated active area are usually damaged during etching with an existing etching process.

In order to better understand the purpose, technical solutions, and technical effects of the present disclosure, the present disclosure will be further explained below in conjunction with the accompanying drawings and embodiments. At the same time, it is stated that the embodiments described below are only used to explain the present disclosure, not to limit the present disclosure.

Unless otherwise defined, all technical and scientific terms used herein have the same meaning as commonly understood by those skilled in the technical field of the disclosure. The terminology used in the specification of the application herein is only for the purpose of describing specific embodiments, and is not intended to limit the application. The term "and/or" as used herein includes any and all combinations of one or more related listed items.

In the case of using the "including", "having", and "including" described in this article, unless a clear qualifying term is used, such as "only", "consisting of", etc., another component or process may be added. Unless mentioned to the contrary, terms in the singular form may include the plural form, and it cannot be understood that the number is one.

In the existing semiconductor process, a one-step etching process is used to dry-etch the substrate to form shallow trenches in the substrate to isolate a number of active regions in the substrate, and then the shallow trenches are filled with an insulating material layer to form shallow trench isolation structures. When using the existing dry etching process to directly etch the substrate to form the active areas, especially as the design dimensions decrease, the ends of such active areas become more and more elongated. Because of high-energy charged particles or groups contained in the etching gas, as the charged particles or groups bombard the substrate to form shallow trenches, they cause damage or destruction to the ends of the active areas, which will have an adverse effect on the performance of the device.

Therefore, based on the above-mentioned problems, there is a need for a method for preparing a semiconductor structure to reduce the damage to the edge of the active region caused by the etching process.

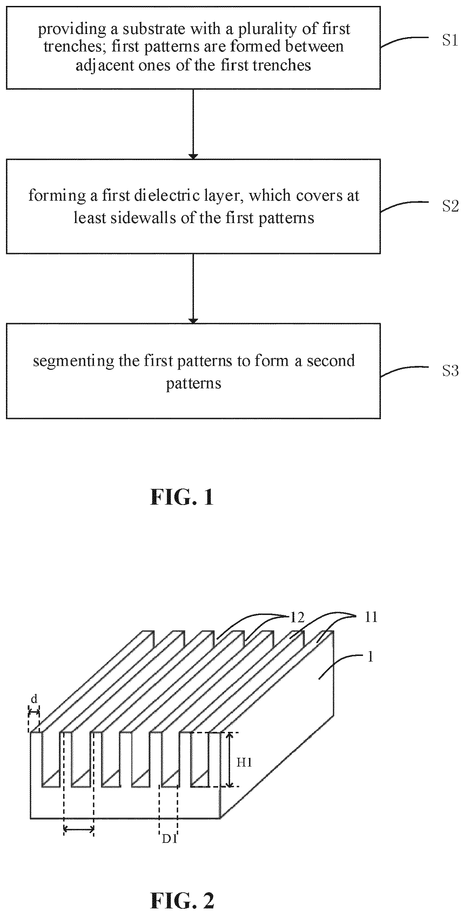

As shown in FIG. 1, the present disclosure provides a method for manufacturing a semiconductor structure, which includes:
S1: providing a substrate with a plurality of first trenches, in which first patterns are formed between adjacent first trenches;
S2: forming a first dielectric layer, which covers at least the sidewalls of the first patterns; and
S3: segmenting the first pattern to form second patterns.

The method for preparing the semiconductor structure according to the present disclosure obtain the active areas composed of the second patterns by forming a first dielectric layer as a protective layer on the sidewalls of the first patterns in the substrate, and then segmenting the first patterns to form the second patterns. In this way, when the second patterns constituting the active areas forms from segmenting the first patterns, the sidewalls of the first patterns are always protected by the first dielectric layer, so the ends of the second patterns (which are the ends of the active areas) are not easily damaged during the segmentation process.

Referring to FIG. 2, S1 includes the steps of:
S11: providing a substrate 1; and
S12: etching the substrate 1 to form a plurality of first trenches 12 in the substrate 1 thus form the first pattern 11 between two adjacent ones of the plurality of first trenches 12.

As an example, at S11, the substrate 1 can be, but not limited to a silicon substrate, a gallium nitride substrate, a silicon-on-insulator or a silicon carbide substrate, etc. In this embodiment, the substrate 1 may be a silicon substrate. A doped well region by applying an ion implantation process may be formed in the substrate 1, and the doping type of the doped well region may be P-type or N-type.

As an example, at S12, the first trenches 12 and the first patterns 11 form a line array structure. Specifically, each line element of the first patterns 11 may be, but is not limited to, a rectangular wall-shaped structure. Herein, the plurality of the first patterns 11 are spaced apart, and the first trenches 12 are formed between adjacent first patterns 11. Specifically, the plurality of the first patterns 11 are arranged in parallel at intervals.

As an example, please refer to FIG. 2. In S12, the width d of a first pattern 11 along the horizontal direction of the substrate 1 can be set according to actual needs. It is worth noting that the width d of the first pattern 11 is the length, along the horizontal direction of the substrate 1, of the cross section perpendicular to the extension direction of the first pattern 11. The width d of the first pattern 11 is ≤ 20 nm, and more specifically, the width d of the first pattern 11 may be 20 nm, 15 nm, or 10nm, etc. Within the width range, the technical problem described in the present disclosure is more prominent, and the technical solution described in this embodiment has better economic efficiency and beneficial technical effects. The distance L between adjacent first patterns 11 may be set according to actual needs. Specifically, the distance L between the adjacent first patterns 11 is ≤30 nm, and more specifically, the distance L between the adjacent first patterns 11 may be 30 nm, 25 nm, 20nm, 15nm or 10nm and so on. It should be noted that the distance between the adjacent first patterns 11 refers to the center-to-center distance between the adjacent two first patterns 11.

As an example, in S12, a SADP (Self-Aligned Double Patterning) process or a SAQP (Self-Aligned Quadruple Patterning) process can be applied to form the line array structure including the plurality of the first patterns 11 and the plurality of first trenches 12 on the substrate 1. The SADP process and the SAQP process are known to those skilled in the art and will not be repeated here.

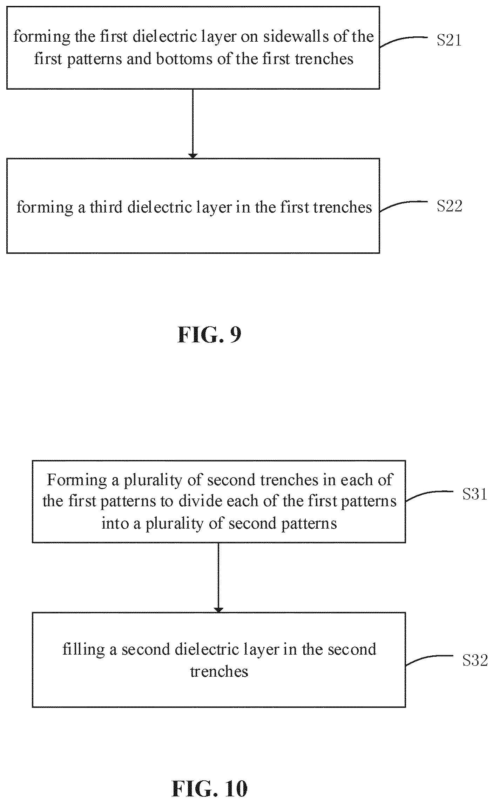

In an example, referring to FIG. 9, S2 further includes the following steps.

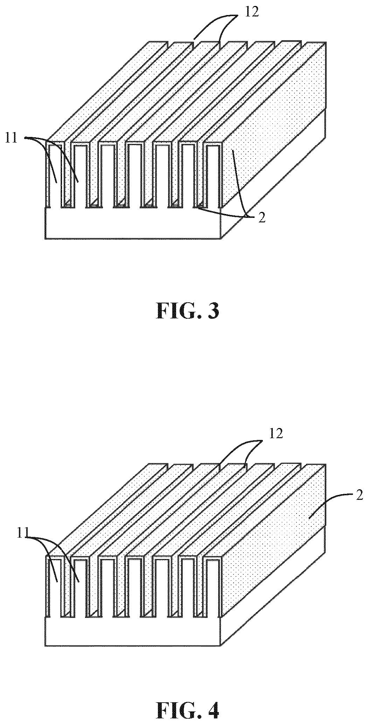

At S21, the first dielectric layer 2 is formed on the sidewalls of the first pattern 11 and the bottom surfaces of the first trenches 12; alternatively, the first dielectric layer 2 is also formed on the sidewalls of the first pattern 11, the bottom surfaces of the first trenches 12, and the top surfaces of the first pattern 11, so that when the second trenches are subsequently formed in an etching process, the first dielectric layer 2 can effectively protect the surfaces of the first pattern 11. In this process, the thickness of the first dielectric layer 2 can be set according to actual needs. Specifically, the thickness of the first dielectric layer 2 is less than half of the width of a first trench 12. In this process, after the first dielectric layer 2 is formed, there is a gap in the first trenches 12, as shown in FIG. 3. Preferably, the thickness of the first dielectric layer 2 is in the range of 1nm-5nm. Within this range, the first dielectric layer 2 can not only provide sufficient protection for the first pattern 11, but also leave enough space for subsequent filling of the third dielectric layer.

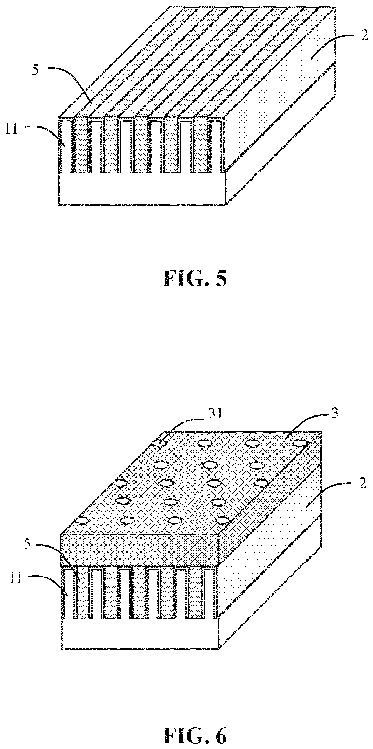

At S22, a third dielectric layer 5 is formed in the first trenches 12 and fills up the first trenches 12. Specifically, the third dielectric layer 5 fills up the gaps between the first dielectric layer 2 in the first trenches 12, as shown in FIG. 5.

More specifically, S22 includes these exemplary steps.

At S221, the third dielectric material layer (not shown) is formed, which fills up the first trenches 12 and covers the first dielectric layer 2 on the top surfaces of the first pattern 11. Specifically, the third dielectric material layer is deposited by a process of, but not limited to, a physical vapor deposition process, a chemical vapor deposition process, an atomic layer deposition process, or a spin coating process; and

At S222, the third dielectric material layer which covers the top surfaces of the first patterns 11 is removed, and the retained third dielectric material layer in the first trenches 12 is as the third dielectric layer 5. Specifically, the third dielectric material layer covering the first dielectric layer 2 on the top surfaces of the first patterns 11 is removed by a process such as, but not limited to, the chemical mechanical polishing process. In another embodiment, the third dielectric material layer is located on the first dielectric layer 2 on the top surfaces of the first patterns 11. The third dielectric material layer both on the first dielectric layer 2 on the top surface of the first pattern 11 and in the first trenches 12 has a continuous flat upper surface.

In one example, referring to FIG. 4, after forming the first dielectric layer 2 and before forming the third dielectric layer 5, the method further includes removing the first dielectric layer 2 located at the bottom surfaces of the first trenches 12. In this way, the first dielectric layer 2 is discontinuous at the bottoms of the first trenches 12 into separated structures, to avoid too many carriers accumulate at the bottoms of the first trenches 12, thereby avoiding leakage current caused by holes or electrons accumulated near the first dielectric layer 2 in the transistor substrate. It is worth noting that the first dielectric layer 2 at the bottoms of the first trenches 12 can be completely removed or partially removed. In this embodiment, all the first dielectric layer 2 at the bottoms of the first trenches 12 is removed.

In another example, S2 includes the following steps of forming a first dielectric layer 2 in the first trenches 12, which fills up the first trenches 12. Specifically, a first dielectric material layer (not shown) is formed in the first trenches 12 and the top surfaces of the first pattern 11 firstly, and then the first dielectric material layer on the top surfaces of the first patterns 11 are removed by a process such as, but not limited to, a chemical mechanical polishing process. The first dielectric material layer remaining in the first trenches 12 is the first dielectric layer.

As an example, a physical vapor formation process, a chemical vapor formation process, an atomic layer formation process or a thermal oxidation process can be used to form the first dielectric layer 2. The first dielectric layer 2 serves as a protective layer for the first patterns 11. The first dielectric layer 2 may include, but is not limited to, a silicon dioxide (SiO₂) layer, a silicon monoxide (SiO) layer, a silicon nitride (SiN) layer, or a silicon oxynitride (SiON) layer, etc. In this embodiment, the first dielectric layer 2 can be a silicon dioxide layer.

As an example, a physical vapor deposition process, a chemical vapor deposition process, an atomic layer deposition process or a spin coating process may be used to form the third dielectric layer 5, and the material of the third dielectric layer 5 is different from the material of the first dielectric layer 2. In this embodiment, the third dielectric layer 5 may include, but is not limited to, a silicon dioxide layer. Specifically, the hardness of the first dielectric layer 2 is greater than the hardness of the third dielectric layer 5, so that the first dielectric layer 2 provides good protection for the first patterns 11. At the same time, under the same etching conditions, the etching rate of the third dielectric layer 5 is greater than the etching rate of the first dielectric layer 2, so as to ensure that when the third dielectric layer 5 is removed, the first dielectric layer 2 on the upper surfaces of the first patterns 11 is hardly removed.

Referring to FIG. 10 in detail, S3 includes the following steps.

At S31, a plurality of second trenches 112 are formed on each of the first patterns 11 to divide each of the first patterns 11 into a plurality of second patterns 111.

As an example, step S31 includes the following steps.

At S311, a mask layer is formed on the upper surface of the substrate 1.

At S312, a patterning process on the mask layer is performed to obtain a patterned mask layer 3. The patterned mask layer 3 includes a plurality of openings 31 penetrating through the mask layer, and the openings 31 define the positions and the shape of the second trenches 112 as shown in FIG. 6. Optionally, the shape of the openings 31 is a circle, an ellipse or a rectangle, etc.

At S313, the first patterns 11 are etched based on the patterned mask 3 to form the plurality of second trenches 112 on the first patterns 11 to divide each of the first patterns 11 into the plurality of second patterns 112.

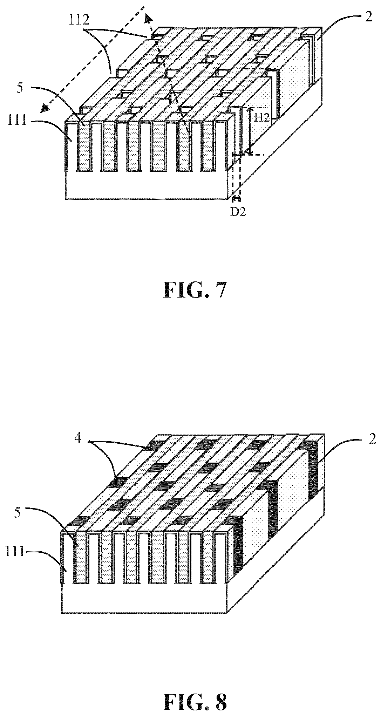

At S314, the patterned mask layer 3 is removed, as shown in FIG. 7.

As an example, in S311, the mask layer 3 may include one of or a combination of at least two of an amorphous carbon layer, a silicon oxynitride layer and a silicon oxide layer, but not limited thereto. Specifically, the mask layer may be formed by at least one of the processes of a physical vapor formation process, a chemical a vapor phase formation process, an atomic layer formation process and a spin coating process.

As an example, in S312, the mask layer 3 may be patterned by a photolithography process to obtain the pattern mask layer 3. The dimension of the openings 31 is larger than the width of each first pattern 11. Specifically, the dimension of the openings 31 may be the size along the width of the first patterns 11, or the maximum size along a horizontal direction of the substrate. For example, the width of the first patterns 11 is less than or equal to 20nm, the size of the second trenches 112 is less than or equal to 15nm, the thickness of the first dielectric layer 2 ranges from 1nm to 5nm, and the size of the openings 31 is less than 30nm. The opening size being larger than the width of the first patterns 11 is beneficial to increase the process window and improves the product yield. It should be noted that the size of the second trenches 112 may be the size along the width direction of the first patterns 11, or the maximum size along a horizontal direction of the substrate.

As an example, in S313, a dry etching process may be used to pattern the first patterns 11 with the patterned mask layer 3. In another example, the second trenches 112 segment the first patterns 11 only, but do not cut the first dielectric layer 2 which covers the sidewalls of the first patterns 11. Specifically, utilizing the pattern of the openings 31, the first patterns 11 are etched with an etching process that has an etch selection ratio of greater than 8 between the first patterns 11 and the first dielectric layer 2 to form the second trenches 112, and second patterns 111 are formed between the first trenches 12 and the second trenches 112. The first dielectric layer 2 on the sidewalls of the second patterns adjacent to the second trenches 112 is not etched. With the etching process having the high etch selection ratio, only the first patterns 11 are etched and segmented, and the whole first dielectric layer 2 is retained intact, which ensures better end shapes of the second patterns 111, thereby improving the device performance.

As an example, in S314, an etching process or a chemical mechanical polishing process may be used to remove the patterned mask layer 3.

By referring to FIG. 7, according to one of the embodiments, the extending direction of the first patterns 11 is obliquely intersected with the arrangement direction of the second trenches 112 with the shortest adjacent distance in each of the columns. Specifically, the second trenches 112 on a same first pattern 11 are arranged at intervals, and the second trenches 112 on the adjacent first patterns 11 are arranged in a staggered way. More specifically, the second trenches 112 located in adjacent odd-numbered columns of the first pattern 11 are arranged in a staggered way with the second trenches 112 located in the nearby even-numbered columns of the first pattern 11, the second trenches 112 located in the adjacent odd-numbered columns of the first pattern 11 are arranged in one-to-one correspondence, and the second trenches 112 in adjacent even-numbered columns of the first pattern 11 are arranged in a one-to-one correspondence. Specifically, the first patterns are the active areas of the storage device, and the above arrangement is beneficial to maximize the device storage density.

According to another embodiment, by referring to FIGS. 1 and 7, the depth H1 of the first trenches 12 may be greater than or equal to the depth H2 of the second trenches 112. In this embodiment, the depth H1 of the first trenches 12 may be greater than the depth H2 of the second trenches 112. As the depth H1 of the first trenches 12 is greater than the depth H2 of the second trenches 112, the isolation effect is better, and thus the mutual influence between the adjacent active areas is avoid. Specifically, the first trenches 12 can be etched with the above process, and the second trenches 112 can be etched later, that is, different depths in H1 of the first trenches 12 and H2 of the second trenches 112 are achieved by twice etching.

According to another embodiment, in FIGS. 1 and 7, the width D1 of the first trenches 12 is narrower than or equal to the width D2 of the second trenches 112. In this embodiment, the width D1 of the first trenches 12 is less than the width D2 of the second trenches 112. It is worth noting that the width of the second trenches 112 refers to the dimension along the extending direction of the first patterns 11. The maximum dimension of the second trenches 112 in a horizontal direction of the substrate 1 is less than 15 nm.

In an example, after the second pattern 111 is formed, S32 is further included, which includes filling a second dielectric layer 4 in the second trenches 112, as shown in FIG. 8.

As an example, the second dielectric layer 4 can be formed by a process of, but not limited to, a physical vapor formation process, a chemical vapor formation process, or an atomic layer formation process. The material of the second dielectric layer 4 is the same the material of the first dielectric layer 2, or it is different from that of the first dielectric layer 2. The material of the second dielectric layer 4 and the material of the third dielectric layer 5 are different. When the materials of the second dielectric layer 4 and the first dielectric layer 2 are different, the second dielectric layer 4 may include, but not limited to, a silicon oxide layer or a silicon nitride (SiN) layer. When the material of the second dielectric layer 4 is different from the material of the third dielectric layer 5, the viscosity of the second dielectric layer 4 is lower than that of the third dielectric layer 5. The first trenches 12 and the second trenches 112 are respectively filled with the third dielectric layer 5 and the second dielectric layer 4 which have different viscosities, ensuring the filling quality and the isolation performance as well.

It should be noted that, according to other embodiments, with respect to the solution in which the first dielectric layer 2 fills up the first trenches 12, before filling the second trenches 112 with the second dielectric layer 4, it may also include the step of removing the first dielectric layer 2 from the first trenches 12, and in this case, while filling the second dielectric layer 4 into the second trenches 112, the first trenches 12 are filled with the second dielectric layer 4. With respect to the solution in which the first trenches 12 is filled up with the third dielectric layer 5, before filling the second dielectric layer 4 into the second trenches 112, it may also include a step of removing the third dielectric layer 5 from the first trenches 12, and in this case, when filling the second dielectric layer 4 into the second trenches 112, the first trenches 12 are filled with the second dielectric layer 4.

The disclosure is simple in manufacture processes and has a broad prospect for applications in the semiconductor manufacturing field, and it effectively overcomes the shortcomings in the related art and having a high industrial application value.

The exemplary embodiments of the present disclosure also provide a semiconductor structure, not part of the present invention. The semiconductor structure may be formed by the method described in the above embodiments. Other methods may also be used.

The semiconductor structure includes: a substrate 1; a number of first trenches 12 and a number of second trenches 112 both located in the substrate 1; second patterns 111 located between the first trenches 12 and the second trenches 112; a first dielectric layer 2, covering at least the sidewalls of the second pattern 111 adjacent to the first trenches 12; and a second dielectric layer 4, filling the second trenches 112.

In one of the examples, the substrate 1 includes, but is not limited to, a silicon substrate, a gallium nitride substrate, a silicon-on-insulator substrate or a silicon carbide substrate, etc. In this embodiment, the substrate 1 may be a silicon substrate. A doped well region formed with an ion implantation process may be formed in the substrate 1, and the dopant type of the doped well region may be either P-type or N-type.

In one of the examples, the depth H1 of the first trenches 12 may be greater than or equal to the depth H2 of the second trenches 112. In this embodiment, the depth H1 of the first trenches 12 being greater than the depth H2 of the second trenches 112 makes the isolation effect better, so to avoid mutual influence between adjacent active areas.

In one of the examples, the material of the second dielectric layer 4 is the same as the material of the first dielectric layer 2, or is different from the material of the first dielectric layer 2. When the materials of the second dielectric layer 4 and the first dielectric layer 2 are different, the second dielectric layer 4 may include, but is not limited to, a silicon oxide layer or a silicon nitride (SiN) layer.

The width of the second patterns 111 is less than or equal to 20 nm. It is worth noting that the width of the second patterns 111 is the length, along the horizontal direction of the substrate 1, of the cross section perpendicular to the extension direction of the second patterns 111. Specifically, the width of the second patterns 111 may be 20 nm, 15 nm, or 10 nm, etc. Within the width range, the technical problem described in the present disclosure is more prominent, and the technical solution described in this embodiment will be more economical and more beneficial. The distance between adjacent second patterns 111 can be set according to actual needs.

In another embodiment, the sidewalls of the second pattern 111 adjacent to the second trenches 112 are not covered with the first dielectric layer 2.

The distance between two adjacent second pattern 111 is ≤ 30 nm. More specifically, the distance between the adjacent second pattern 111 may be 30 nm, 25 nm, 20 nm, 15 nm, or 10 nm, etc., but in other embodiments, the distance between two adjacent second patterns 111 is not limited to the above-mentioned values. It should be noted that the distance between two adjacent ones of the second patterns 111 mentioned herein refers to the center-to-center distance between two adjacent second patterns 111.

The maximum dimension of one of the second trenches 112 in a horizontal direction of the substrate 1 is less than 15 nm.

The semiconductor structure further includes a third dielectric layer 5, and the third dielectric layer 5 fills in the first trenches 12.

The material of the third dielectric layer 5 is different from the material of the first dielectric layer 2. In this embodiment, the third dielectric layer 5 may include, but is not limited to, a silicon dioxide layer.

In one example, the material of the second dielectric layer 4 and the material of the third dielectric layer 5 are different. When the material of the second dielectric layer 4 is different from the material of the third dielectric layer 5, the viscosity of the second dielectric layer 4 is lower than that of the third dielectric layer 5. The first trench 12 and the second trench 112 are respectively filled with the third dielectric layer 5 and the second dielectric layer 4 which have different viscosities, thereby ensuring both the filling effect and the isolation performance. Specifically, the width of the first patterns 11 is less than or equal to 20 nm, the distance between adjacent first patterns 11 is less than or equal to 30 nm, the size of the second trenches 112 is less than or equal to 15 nm, and the thickness of the first dielectric layer 2 ranges from 1 nm to 5 nm. The spin coating process may be used to fill the first trenches 12 and the second trenches 112. Since the filling difficulty of the second trenches 112 is higher than that of the first trenches 12, the second trenches 112 are filled with the second dielectric layer 4 with a low viscosity to obtain a better filling effect, and the first trenches 12 can be filled with a high-viscosity third dielectric layer 5 to obtain a better isolation performance. It should be noted that the size of the second trenches 112 may be the size along the width direction of the first patterns 11, or the maximum size along the horizontal direction of the substrate.

In another example, the first dielectric layer 2 is also present between the adjacent second patterns 111 and is integrated with the first dielectric layer 2 on the sidewalls of the second patterns 111. Specifically, the second trenches 112 only segment the first patterns 11, and the first dielectric layer 2 covering the sidewalls of the first patterns 11 is not segmented. By utilizing the openings 31, an etching process with an etch selection ratio greater than 8 between the first patterns 11 and the first dielectric layer 2, the first patterns 11 are patterned to form the second trenches 112. The second patterns 111 are formed between the first trenches 12 and the second trenches 112 , and the first dielectric layer 2 on the sidewalls of the second patterns 111 adjacent to the second trenches 112 is not segmented by this etching. In the process with the high etch selection ratio, only the first patterns 11 are segmented and the first dielectric layer 2 is retained intact, so the end shape of the resultant second patterns 111 will be better ensured, thereby improving the device performance.

It should be understood that, although the steps disclosed in the flowcharts of the drawings are shown in sequence as indicated by the arrows, these steps are not necessarily performed in the order as indicated. Unless there is a clear description in this disclosure, no strict order for executing these steps, so these steps may be executed in other orders. Moreover, at least some of the steps in the flowcharts may include multiple steps or multiple stages. These steps or stages are not necessarily executed at the same time, instead they may be executed at different times, and the order of execution of these steps or stages is not necessarily in sequence. They may be performed in turn or alternately with other steps, or at least a part of steps or stages of said other steps.

The technical features of the above-mentioned embodiments can be combined in any ways necessary. In order to describe the disclosure concisely, not all possible combinations of the various technical features in the above-mentioned embodiments are described. However, as long as there is no contradiction in combining these technical features, all should be considered as within the scope of this specification.

The above-mentioned descriptions only show several embodiments of the present disclosure, and the descriptions are relatively specific and detailed, but these should not be interpreted as limiting the scope of the disclosure.

## Claims

1. A method for manufacturing a semiconductor structure, comprising:
(S1) providing a substrate (1), wherein the substrate (1) comprises a plurality of first trenches (12), and first patterns (11) are formed by a single material between adjacent ones of the plurality of first trenches (12),
(S21) forming a first dielectric layer (2) on sidewalls of the first patterns (11) and bottoms of the first trenches (12);
(S22) forming a third dielectric layer (5) in the first trenches (12), wherein the third dielectric layer (5) fills up the first trenches (12), a hardness of the first dielectric layer (2) is greater than a hardness of the third dielectric layer (5);
(S31) forming a plurality of second trenches (112) in each of the first patterns (11) to divide each of the first patterns (11) into a plurality of second patterns (111) by etching part of the first patterns (11) with an etch selection ratio of greater than 8 between the first patterns (11) and the first dielectric layer (2) to form a plurality of active areas constituted by the plurality of second patterns (111), wherein the first dielectric layer (2) is retained intact between adjacent second patterns (111); and
(S32) filling a second dielectric layer (4) in the second trenches (112),
wherein a width of the first patterns (11) is ≤ 20 nm, a distance between the adjacent ones of the first patterns (11) is ≤ 30 nm, a maximum dimension of the second trenches (112) along a horizontal direction of the substrate (1) is less than 15 nm.

2. The method for manufacturing a semiconductor structure according to claim 1, wherein after forming the first dielectric layer (2) and before forming the third dielectric layer (5), removing the first dielectric layer (2) from the bottoms of the first trenches (12).

3. The method for manufacturing a semiconductor structure according to claim 1, wherein a material of the third dielectric layer (5) is different from a material of the first dielectric layer (2).

4. The method of manufacturing a semiconductor structure according to claim 1, wherein a depth of the first trenches (12) is greater than a depth of the second trenches (112); and/or a width of the first trenches (12) is smaller than a width of the second trenches (112).

5. The method of manufacturing the semiconductor structure according to claim 1, wherein the first patterns (11) are arranged in parallel and spaced apart.

6. The method of manufacturing the semiconductor structure according to claim 1, wherein the second trenches (112) only segment the first patterns (11) into the plurality of second patterns (111) and the first dielectric layer (2) is retained between two adjacent ones of the plurality of second patterns (111) respectively located at both sides of each second trench.

## Patentansprüche

1. **Verfahren** zum Herstellen einer Halbleiterstruktur, umfassend:
(S1) Bereitstellen eines Substrats (1), wobei das Substrat (1) eine Vielzahl von ersten Gräben (12) umfasst und erste Muster (11) durch ein einziges Material zwischen benachbarten Gräben der Vielzahl von ersten Gräben (12) gebildet werden,
(S21) Bilden einer ersten dielektrischen Schicht (2) auf den Seitenwänden der ersten Muster (11) und den Böden der ersten Gräben (12);
(S22) Bilden einer dritten dielektrischen Schicht (5) in den ersten Gräben (12), wobei die dritte dielektrische Schicht (5) die ersten Gräben (12) auffüllt und eine Härte der ersten dielektrischen Schicht (2) größer ist als eine Härte der dritten dielektrischen Schicht (5);
(S31) Bilden einer Vielzahl von zweiten Gräben (112) in jedem der ersten Muster (11), um jedes der ersten Muster (11) in eine Vielzahl von zweiten Mustern (111) zu unterteilen, indem ein Teil der ersten Muster (11) mit einem Ätzauswahlverhältnis von größer als 8 zwischen den ersten Mustern (11) und der ersten dielektrischen Schicht (2) geätzt wird, um eine Vielzahl von aktiven Bereichen zu bilden, die durch die Vielzahl von zweiten Mustern (111) gebildet werden, wobei die erste dielektrische Schicht (2) zwischen benachbarten zweiten Mustern (111) intakt gehalten wird; und
(S32) Auffüllen einer zweiten dielektrischen Schicht (4) in den zweiten Gräben (112),
wobei eine Breite der ersten Muster (11) ≤ 20 nm ist, ein Abstand zwischen den benachbarten der ersten Muster (11) ≤ 30 nm beträgt und eine maximale Abmessung der zweiten Gräben (112) entlang einer horizontalen Richtung des Substrats (1) weniger als 15 nm beträgt.

2. Verfahren zum Herstellen einer Halbleiterstruktur nach Anspruch 1, wobei nach dem Bilden der ersten dielektrischen Schicht (2) und vor dem Bilden der dritten dielektrischen Schicht (5) die erste dielektrische Schicht (2) von den Böden der ersten Gräben (12) entfernt wird.

3. Verfahren zum Herstellen einer Halbleiterstruktur nach Anspruch 1, wobei sich ein Material der dritten dielektrischen Schicht (5) von einem Material der ersten dielektrischen Schicht (2) unterscheidet.

4. Verfahren zum Herstellen einer Halbleiterstruktur nach Anspruch 1, wobei eine Tiefe der ersten Gräben (12) größer ist als eine Tiefe der zweiten Gräben (112); und/oder eine Breite der ersten Gräben (12) kleiner ist als eine Breite der zweiten Gräben (112).

5. Verfahren zum Herstellen einer Halbleiterstruktur nach Anspruch 1, wobei die ersten Muster (11) parallel und mit Abstand zueinander angeordnet sind.

6. Verfahren zum Herstellen einer Halbleiterstruktur nach Anspruch 1, wobei die zweiten Gräben (112) die ersten Muster (11) nur in die Vielzahl der zweiten Muster (111) unterteilen und die erste dielektrische Schicht (2) zwischen zwei benachbarten der Vielzahl der zweiten Muster (111), die sich jeweils auf beiden Seiten jedes zweiten Grabens befinden, gehalten wird.

## Revendications

1. **Procédé** de fabrication d'une structure semi-conductrice, comprenant :
(S1) fournir un substrat (1), dans lequel le substrat (1) comprend une pluralité de premières tranchées (12), et les premiers motifs (11) sont formés par un seul matériau entre les parties adjacentes de la pluralité de premières tranchées (12),
(S21) former une première couche diélectrique (2) sur les parois latérales des premiers motifs (11) et les fonds des premières tranchées (12) ;
(S22) former une troisième couche diélectrique (5) dans les premières tranchées (12), la troisième couche diélectrique (5) remplissant les premières tranchées (12), une dureté de la première couche diélectrique (2) étant supérieure à une dureté de la troisième couche diélectrique (5) ;
(S31) former une pluralité de deuxièmes tranchées (112) dans chacun des premiers motifs (11) pour diviser chacun des premiers motifs (11) en une pluralité de deuxièmes motifs (111) en gravant une partie des premiers motifs (11) avec un rapport de sélection de gravure supérieur à 8 entre les premiers motifs (11) et la première couche diélectrique (2) pour former une pluralité de zones actives constituées par la pluralité de deuxièmes motifs (111), dans laquelle la première couche diélectrique (2) est conservée intacte entre les deuxièmes motifs (111) adjacents ; et
(S32) remplir une deuxième couche diélectrique (4) dans les deuxièmes tranchées (112),
dans lequel la largeur des premiers motifs (11) est de ≤ 20 nm, la distance entre les motifs adjacents (11) est de ≤ 30 nm, la dimension maximale des deuxièmes tranchées (112) le long d'une direction horizontale du substrat (1) est inférieure à 15 nm.

2. Procédé de fabrication d'une structure semi-conductrice selon la revendication 1, dans lequel, après avoir formé la première couche diélectrique (2) et avant de former la troisième couche diélectrique (5), la première couche diélectrique (2) est enlevée du fond des premières tranchées (12).

3. Procédé de fabrication d'une structure semi-conductrice selon la revendication 1, dans lequel un matériau de la troisième couche diélectrique (5) est différent d'un matériau de la première couche diélectrique (2).

4. Procédé de fabrication d'une structure semi-conductrice selon la revendication 1, dans lequel la profondeur des premières tranchées (12) est supérieure à la profondeur des deuxièmes tranchées (112) ; et/ou la largeur des premières tranchées (12) est inférieure à la largeur des deuxièmes tranchées (112).

5. Procédé de fabrication de la structure semi-conductrice selon la revendication 1, dans lequel les premiers motifs (11) sont disposés en parallèle et espacés les uns des autres.

6. Procédé de fabrication de la structure semi-conductrice selon la revendication 1, dans lequel les deuxièmes tranchées (112) ne font que segmenter les premiers motifs (11) en une pluralité de deuxièmes motifs (111) et la première couche diélectrique (2) est retenue entre deux motifs adjacents de la pluralité de deuxièmes motifs (111) respectivement situés de part et d'autre de chaque deuxième tranchée.
